# EUROPEAN PATENT SPECIFICATION

(11) **EP 0 324 661 B1**
(45) Date of publication and mention of the grant of the patent: **15.03.1995**
(21) Application number: 89300372.3
(22) Date of filing: 16.01.1989
(51) Int. Cl.: H01L 39/12, H01L 39/24

(54) **Novel superconductors and processes for their preparation**
Supraleiter und Verfahren zu deren Herstellung
Supraconducteurs et procédé pour leur préparation

(30) Priority: 15.01.1988 US 144114; 12.02.1988 US 155247
(43) Date of publication of application: 19.07.1989
(73) Proprietor: UNIVERSITY OF ARKANSAS, Fayetteville, Arkansas 72701 (US)
(72) Inventor: Hermann, Allen M., Fayetteville Arkansas 72701 (US); Sheng Zhengzhi, Fayetteville Arkansas 72701 (US)
(74) Representative: Sheard, Andrew Gregory

(56) References cited:
- EP-A- 0 284 062
- EP-A- 0 321 184
- PHYSICA B, vol. 148, no. 1-3, December 1987, pages 336-338, Elsevier Science Publishers B.V., Amsterdam, NL & Yamada Conference XVIII on superconductivity in highly correlated fermion systems (YCS '87), Sendai, JP, 31 August - 3 September 1987; Y. SAITO et al.:"Hight-tc superconducting properties in (Y1-xTlx)Ba2Cu3O7-y, Y(Ba1-xKx)2Cu3O7-y and YBa2(Cu1-xMgx)3O7-y"
- NATURE, vol. 332, 3rd March 1988, pages 55-58, Basingstoke, GB; Z.Z. SHENG et al.: "Superconductivity in the rare-earth-free Tl-Ba-Cu-O system above liquid-nitrogen temperature"
- High Temperature Superconductivity, Ed. J.W.Lynn, Graduate Texts in Contemporary Physics, Springer verlag, 1990, pp. 142-144

## Description

The present invention relates to high temperature superconductors and methods of their preparation.

Recently, there has been much work done on the utilization of ternary oxides containing rare earth elements, barium, and copper for superconductivity above the temperature of liquid nitrogen. To date, these systems typically require four elements: a rare earth; an alkaline earth; copper; and oxygen. Superconductor systems based on rare earth elements have not been entirely satisfactory. The use of rare earth elements in the production of superconductors increases the cost of the resultant superconductors because these rare earth elements are in relatively short supply and are expensive. Furthermore, these systems typically exhibit limited transition temperatures at or below 93 K. Partial substitutions of elements for the member(s) in these systems have not produced significantly higher temperature superconductors.

Y. Saito *et al*, *Physica* **148B**: 336-338 (1987) relates to studies of transition temperature T_{c} in compounds of the formula (Y₁₋ₓTlₓ)Ba₂Cu₃O_{7-y} where x is various values from 0 to 1.0.

Typical high temperature superconductive systems based on rare earth elements also suffer from the disadvantage of not being producible in an expedient manner. Therefore, typical methods for producing these high temperature superconductive systems do not provide low cost processing and manufacturability.

Accordingly, there is a need for new superconductive systems and processes for making such systems.

Furthermore, many of the superconductor compositions that have been proposed to date are based on rare earth metals. Due to the short supply and cost of these rare earth metals, the compositions constructed therefrom can be quite expensive.

Accordingly, there is a need for improved superconductors with higher transition temperatures.

The present invention encompasses new high temperature superconductive systems and methods of making such systems. These are free of rare earth elements and are based on thallium. Therefore, according to a first aspect of the present invention there is provided a high temperature superconductive system, which comprises a compound of the general formula:

TlBaₐCu_{b}O_{c}

wherein:
a has a value greater than or equal to 0.2 and less than or equal to 5;
b has a value greater than or equal to 0.5 and less than or equal to 15; and
c has a value greater than or equal to a+b and less than or equal to 2+a+b;

the compound having a critical temperature of at least 85K.

The present invention thus provides new high temperature superconductor compounds and methods for their production, where the term "high temperature" refers to a temperature above the boiling point of liquid nitrogen. The present invention may also provide new superconductive compounds that may produce higher temperature, even room temperature, superconductors by further elemental substitution and variation of preparation procedures.

The compounds of the present invention eliminate the need for using rare earth elements and are based on thallium (Tl). The compounds may be superconducting with a critical temperature of at least 85 K with indications of smaller superconductive phase at 270 K. Furthermore, the inventors have found that these superconductors may be rapidly produced at relatively low temperatures.

Preferred ranges of the stoichiometric ratios a, b and c in the compounds of the invention are as follows:
i) a is greater than or equal to 0.5 and less than or equal to 2, such as 1.3;
ii) b is greater than or equal to 0.6 and less than or equal to 6, such as from 1.5 to 2 inclusive;
iii) c is greater than or equal to 3.5 and less than or equal to 6.5, such as from 4.3 to 5.5.

According to a second aspect of the present invention there is provided a process for the preparation of a superconducting compound of the general formula:

TlBaₐCu_{b}O_{c}

wherein:
a has a value greater than or equal to 0.2 and less than or equal to 5;
b has a value greater than or equal to 0.5 and less than or equal to 15; and
c has a value greater than or equal to a+b and less than or equal to 2+a+b;

the compound having a critical temperature of at least 85K, the process comprising:
(a) admixing copper oxide, barium carbonate and optionally thallium oxide;
(b) optionally grinding and heating the resultant mixture;
(c) admixing the resultant mixture with Tl₂O₃ (if not already added); and
(d) heating the resultant mixture in air or an oxygen flow.

The compound prepared according to the second aspect has the same features as for the first aspect mutatis mutandis.

Preferably the optional heating in (b) is at a temperature of from 900 to 950°C, e.g. at 925°C for at least 24 hours. It is also advantageous that the heating step in (d) is at a temperature of from 900-950°C and/or in an oxygen flow for 2 to 5 minutes.

Suitably the molar ratio BaCO₃:CuO, is from 1:2.5 to 1:3.5, such as 1:3, and the resultant mixture in (b) comprises BaCu₃O₄, and/or the molar ratio of BaCu₃O₄:Tl₂O₃ in (c) is from 1:0.5 to 1:1. Further advantages may be achieved if the mixture is ground and optionally compressed into a pellet in (b) and/or (d).

A particularly preferred process for preparing compounds of the present invention comprises:
a) mixing BaCO₃ and CuO;
b) grinding the resultant mixture then heating the mixture in air to obtain a uniform black BaCu₃O₄ powder;
c) mixing the resultant BaCu₃O₄ powder with Tl₂O₃;
d) regrinding the mixture;
e) pressing the ground mixture into a pellet;
f) heating the pellet in flowing oxygen; and
g) removing the pellet from the heat after it has slightly melted and quenching it in air to room temperature. The BaCu₃O₄ powder may be mixed with Tl₂O₃ in a molar ratio of from 1:0.5 to 1:1, such as 1:0.5, 1:0.75 or in a molar ratio of 1:1 where the pellet is removed from the heat after it is completely melted. Usually the BaCO₃ and CuO are mixed in a 1:3 molar ratio.

The mixture in (b) may be heated to a temperature of from 850-950°C, preferably from 900 to about 950°C, e.g. 925 to about 950°C, suitably for about 2 hours in flowing air.

Another preferred process to prepare compounds of the present invention comprises:
a) mixing Tl₂O₃, BaCO₃, and CuO;
b) grinding the mixture and pressing the ground mixture into a pellet;
c) heating the pellet; and
d) removing the pellet from the heat after it has slightly melted and quenching the pellet in air to room temperature.

The amounts of Tl₂O₃, BaCO₃, and CuO may be provided so that they have a nominal composition of Tl_{0.5}BaCu₃O_{4.8+X}, Tl₂BaCu₃O_{7+X}, Tl₅BaCu₃O_{11.5+X}, TlBa₂Cu₃O_{6.5+X}, or TlBaCu₃O_{5.5+X}.

Preferably the BaCO₃ and CuO are mixed in a 2:3 molar ratio.

The processes of the present invention allow the compounds to be prepared at temperatures of approximately 850 to about 950°C in flowing oxygen. Accordingly, the methods of the present invention may allow the superconductor to be made at relatively low temperatures. Furthermore, the method of the present invention may allow the superconductor compounds to be produced rapidly, in approximately 30 minutes.

The invention will now be described, by way of example only, with reference to the accompanying drawings, in which:
Figure 1 illustrates variations in the electrical resistance vis-a-vis temperature of two Tl-Ba-Cu-O superconductor samples in accordance with the present invention; and
Figure 2 illustrates the electrical resistance vis-a-vis temperature of a Tl-Ba-Cu-O sample in accordance with the present invention.

In some of the Examples use is made of the symbol X in the stoichiometric amounts of oxygen in certain compounds. It is to be understood that the range of values of X is such that the stoichiometric amount of oxygen falls within the limits prescribed for the present invention.

### EXAMPLE 1

A. The following reagents were utilized:
   1. Tl₂O₃,
   2. BaCO₃,
   3. CuO.
B. The following procedure was followed:
   1. The mixture of a one molar portion of BaCO₃ and a three molar portion of CuO was ground with an agate mortar and pestle, heated in air at approximately 925°C for more than 24 hours (with several intermediate grindings) to obtain a uniform black powder having the nominal formula BaCu₃O₄.
   2. The resulting BaCu₃O₄ powder was mixed with Tl₂O₃ to a molar ratio of 1:0.5. The mixture was completely ground and then pressed into a pellet.
   3. A tube furnace was heated to a temperature of approximately 880 to about 900°C in flowing oxygen.
   4. The pellet was then placed in the tube furnace for 2-5 minutes while the temperature and oxygen flow were maintained.
   5. After the pellet was slightly melted it was taken out of the furnace and quenched in air until it reached room temperature.

By visual inspection, it was determined that the Tl₂O₃ had been partially volatilized as black smoke, part had become a light yellow liquid, and part had reacted with the Ba-Cu oxide to form a partially melted black porous material which is multiphase and superconductive. The samples prepared by this procedure had an onset temperature of about 96 K, a midpoint of about 85 K, and a zero resistance temperature of about 81 K.

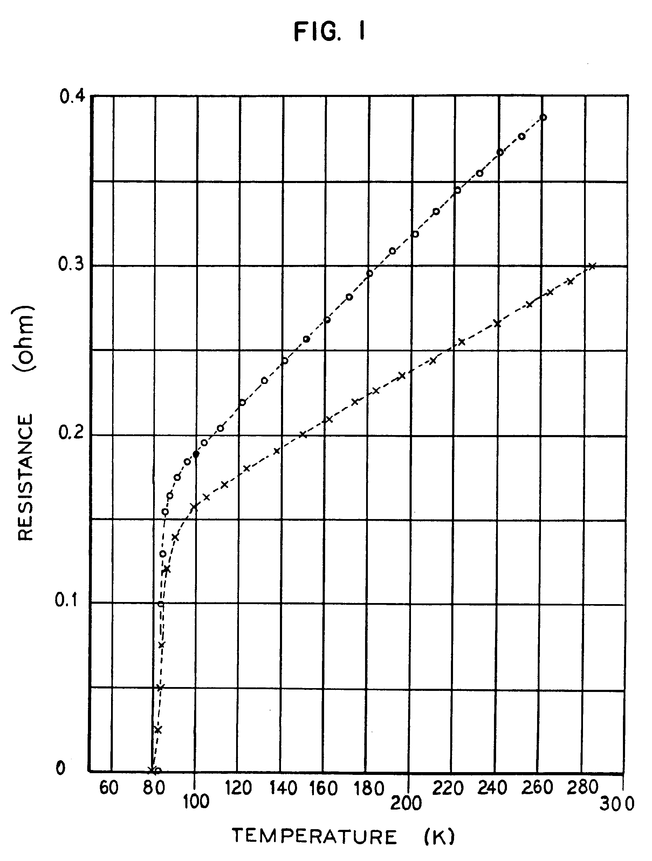

Figure 1 illustrates resistance versus temperature dependencies down to the boiling point of liquid nitrogen (77 K) for two samples made pursuant to the procedure of this example. The samples were measured in a simple liquid nitrogen Dewar. Quantitative magnetic examinations of Meissner effect flux expulsion confirmed that the sharp drop of resistance originated from the superconductivity of these samples.

### EXAMPLE 2

A. The following reagents were utilized:
   1. Tl₂O₃,
   2. BaCO₃,
   3. CuO.
B. The following procedure was followed:
   1. A mixture of a one molar portion of BaCO₃ and a three molar portion of CuO was ground with an agate mortar and pestle. The ground mixture was heated in air at approximately 925°C for more than 24 hours with several intermediate grindings to obtain a uniform black powder having a nominal composition BaCu₃O₄.
   2. The resulting BaCu₃O₄ powder was mixed with Tl₂O₃ in a molar ratio of 1:1, completely ground, and pressed into a pellet.
   3. A tube furnace was heated to approximately 950°C in flowing oxygen.
   4. The pellet was then placed in the tube furnace for 2-5 minutes while maintaining the temperature and oxygen flow.
   5. After the pellet had completely melted, it was taken out of the furnace and quenched in air until it reached room temperature.

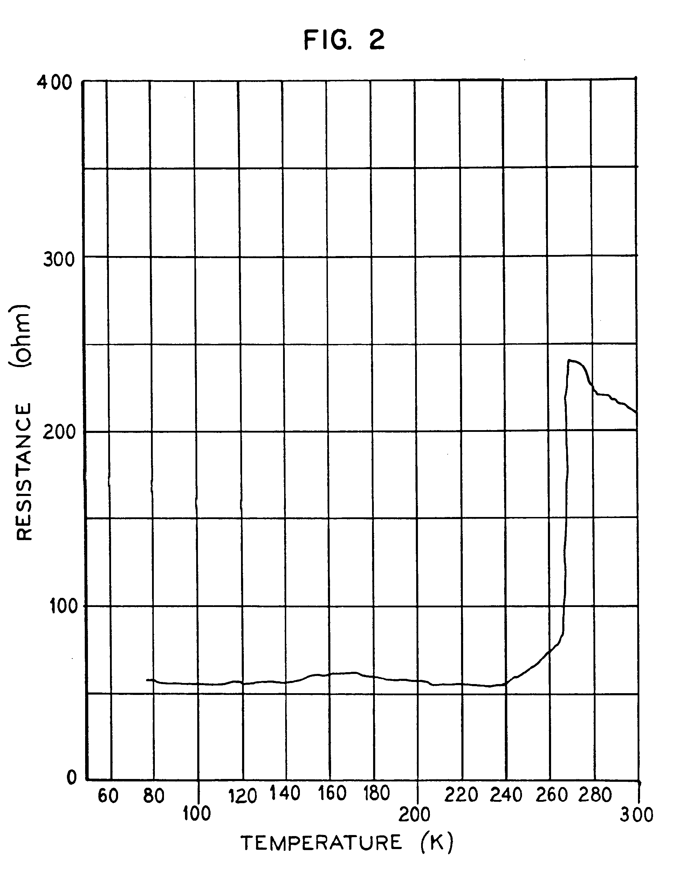

The melted sample had visible crystalline grains. Figure 2 illustrates the electrical resistance versus temperature for a superconductor constructed pursuant to this example. As illustrated, resistance-temperature dependence showed a sharp drop of resistance at about 270 K, which suggests a very high temperature superconducting phase in this sample.

### EXAMPLE 3

A. The following reagents were utilized:
   1. Tl₂O₃,
   2. BaCO₃,
   3. CuO.
B. The following procedure was followed:
   1. A mixture of a two molar portion of BaCO₃ and a three molar portion of CuO was ground with an agate mortar and pestle, heated in air at approximately 925°C for more than 24 hours (with several intermediate grindings) to obtain a uniform black powder having the nominal composition Ba₂Cu₃O₅.
   2. The resultant Ba₂Cu₃O₅ powder was mixed with Tl₂O₃ to a molar ratio of 1:0.75, completely ground, and pressed into a pellet.
   3. A tube furnace was heated to a temperature of approximately 880 to about 900°C in flowing oxygen.
   4. The pellet was placed in the tube furnace for 2-5 minutes while maintaining the temperature and oxygen flow.
   5. After the pellet had slightly melted it was taken out of the furnace and quenched in air until it reached room temperature.

The samples prepared by this procedure have been found to be superconductive and have an onset temperature of about 96 K, a midpoint of about 85 K, and a zero resistance temperature of about 81K.

### EXAMPLE 4

A. The following reagents were utilized:
   1. Tl₂O₃,
   2. BaCO₃,
   3. CuO.
B. The following procedure was followed:
   1. Appropriate amounts of Tl₂O₃, BaCO₃ and CuO with a nominal composition of TlBaCu₃O_{5.5+x} were mixed and ground, and pressed into a pellet.
   2. A tube furnace was heated to a temperature of approximately 900 to about 950°C in flowing oxygen.
   3. The pellet was placed in the tube furnace for 2-5 minutes while the temperature and oxygen flow were maintained.
   4. After the pellet had slightly melted, the pellet was taken out from the furnace and was quenched in air to room temperature.

The heated partially melted sample exhibited superconductive properties. The onset temperature (sharp resistance decrease) for this sample was about 90 K.

### EXAMPLE 5

A. The following reagents were utilized:
   1. Tl₂O₃,
   2. BaCO₃,
   3. CuO.
B. The same procedure was followed as set forth in Example 4 above except that the nominal composition of the sample was Tl_{0.5}BaCu₃O_{4.8+X}. The heated (partially melted) sample was superconductive. The onset temperature (sharp resistance decrease) for this sample was about 90 K.

### EXAMPLE 6

A. The following reagents were utilized:
   1. Tl₂O₃,
   2. BaCo₃,
   3. CuO.
B. The same procedure was followed as set forth in Example 4 above except that the nominal composition of the sample was Tl₂BaCu₃O_{7+X}. The heated (partially melted) sample was superconductive. The onset temperature (sharp resistance decrease) for this sample was about 90 K.

### EXAMPLE 7

A. The following reagents were utilized:
   1. Tl₂O₃,
   2. BaCo₃,
   3. CuO.
B. The same procedure was followed as set forth in Example 4 above except that the nominal composition of the sample was Tl₅BaCu₃O_{11.5+X}. The heated (partially melted) sample was superconductive. The onset temperature (sharp resistance decrease) for this sample was about 90 K.

### EXAMPLE 8

A. The following reagents were utilized:
   1. Tl₂O₃,
   2. BaCO₃,
   3. CuO.
B. The same procedure was followed as set forth in Example 4 above except that the nominal composition of the sample was TlBa₂Cu₃O_{6.5+X}. The heated sample had partially melted and was superconductive. The onset temperature (sharp resistance decrease) for this sample was about 90 K.

### EXAMPLE 9

A. The following reagents were utilized:
   1. Tl₂O₃,
   2. BaCO₃,
   3. CuO.
B. The following procedure was followed:
   1. A mixture of a one molar portion of BaCO₃ and a three molar portion of CuO was ground with an agate mortar and pestle, then heated in air at approximately 925°C for 2 hours, and reground.
   2. The resulting BaCu₃O₄ powder was put into a quartz boat, and lightly pressed with an agate pestle.
   3. Tl₂O₃ crystalline powder having approximately half the weight of the BaCu₃O₄ powder was put on the BaCu₃O₄, and heated in a tube furnace in air at a temperature of approximately 900 to about 950°C for about 30 minutes.
   4. After almost all of the Tl₂O₃ had disappeared (by being volatized, melted and/or reacted), the heated sample was taken from the furnace and quenched in air to room temperature.

By visual inspection, it was determined that the Tl₂O₃ had partially volatilized as black smoke, part of the Tl₂O₃ had become a light yellow liquid, and part had reacted with Ba-Cu oxide to form a black porous material which is multiphase and superconductive. This superconductor material had a transition temperature of 78 K (the transition temperature specified here represents the midpoint of the 90% resistance and 10% resistance points in the transition region).

## Claims

1. A superconducting compound of the general formula
TlBaₐCu_{b}O_{c}
wherein:
a has a value greater than or equal to 0.2 and less than or equal to 5;
b has a value greater than or equal to 0.5 and less than or equal to 15; and
c has a value greater than or equal to a+b and less than or equal to 2+a+b;
the compound having a critical temperature of at least 85K.

2. A compound according to claim 1 in which:
i) 0.5 ≦ a ≦ 2;
ii) 0.6 ≦ b ≦ 6; and
iii) 3.5 ≦ c ≦ 6.5.

3. A compound according to claim 1 or 2 which has the nominal composition:
Tl_{0.5}BaCu₃O_{4.8+x};
Tl₂BaCu₃O₇₊ₓ;
Tl₅BaCu₃O_{11.5+x};
TlBa₂Cu₃O_{6.5+x};
or
TlBaCu₃O_{5.5+x}.

4. A process for the preparation of a superconducting compound of the general formula:
TlBaₐCu_{b}O_{c}
wherein:
a has a value greater than or equal to 0.2 and less than or equal to 5;
b has a value greater than or equal to 0.5 and less than or equal to 15; and
c has a value greater than or equal to a+b and less than or equal to 2+a+b;
the compound having a critical temperature of at least 85K, the process comprising:
(a) admixing copper oxide, barium carbonate and optionally thallium oxide;
(b) optionally grinding and heating the resultant mixture;
(c) admixing the resultant mixture with Tl₂O₃, if not already added; and
(d) heating the resultant mixture in air or an oxygen flow.

5. A process as claimed in claim 4 wherein the optional heating in (b) is at a temperature of from 900 to 950°C for at least 24 hours.

6. A process as claimed in claim 4 or 5 wherein the heating in (d) is at a temperature of from 900 to 950°C and/or in an oxygen flow for 2 to 5 minutes.

7. A process according to any of claims 4 to 6 in which:
i) 0.5 ≦ a ≦ 2;
ii) 0.6 ≦ b ≦ 6; and
iii) 3.5 ≦ c ≦ 6.5.

8. A process according to any of claims 4 to 7 wherein the compound has the nominal composition:
Tl_{0.5}BaCu₃O_{4.8+x};
Tl₂BaCu₃O₇₊ₓ;
Tl₅BaCu₃O_{11.5+x};
TlBa₂Cu₃O_{6.5+x};
or
TlBaCu₃O_{5.5+x}.

## Patentansprüche

1. Supraleitende Verbindung der allgemeinen Formel
TlBaₐCu_{b}O_{c}
wobei:
a ein Wert größer oder gleich 0,2 und kleiner oder gleich 5 ist,
b ein Wert größer oder gleich 0,5 und kleiner oder gleich 15 ist,
c ein Wert größer oder gleich a+b und kleiner oder gleich 2+a+b ist; und
die Verbindung eine kritische Temperatur von mindestens 85K aufweist.

2. Verbindung nach Anspruch 1, wobei:
i) 0,5 ≦ a ≦ 2,
ii) 0,6 ≦ b ≦ 6 und
iii) 3,5 ≦ c ≦ 6,5.

3. Verbindung nach Anspruch 1 oder 2 mit der nominalen Zusammensetzung:
Tl_{0,5}BaCu₃O_{4,8+x},
Tl₂BaCu₃O₇₊ₓ,
Tl₅BaCu₃O_{11,5+x},
TlBa₂Cu₃O_{6,5+x}
oder
TlBaCu₃O_{5,5+x}.

4. Verfahren zur Herstellung einer supraleitenden Verbindung der allgemeinen Formel
TlBaₐCu_{b}O_{c}
wobei:
a ein Wert größer oder gleich 0,2 und kleiner oder gleich 5 ist,
b ein Wert größer oder gleich 0,5 und kleiner oder gleich 15 ist,
c ein Wert größer oder gleich a+b und kleiner oder gleich 2+a+b ist; und
die Verbindung eine kritische Temperatur von mindestens 85K aufweist; umfassend
(a) Vermischen von Kupferoxid, Bariumcarbonat und gegebenenfalls Thalliumoxid,
(b) gegebenenfalls Mahlen und Erhitzen der so erhaltenen Mischung,
(c) Vermischen der so erhaltenen Mischung mit Tl₂O₃, falls noch nicht zugegeben, und
(d) Erhitzen der so erhaltenen Mischung in Luft oder einem Sauerstoffstrom.

5. Verfahren nach Anspruch 4, wobei das wahlweise Erhitzen in (b) bei einer Temperatur von 900 bis 950°C mindestens 24 Stunden lang durchgeführt wird.

6. Verfahren nach Anspruch 4 oder 5, wobei das Erhitzen in (d) bei einer Temperatur von 900 bis 950°C und/oder in einem Sauerstoffstrom 2 bis 5 Minuten lang durchgeführt wird.

7. Verfahren nach einem der Ansprüche 4 bis 6, wobei:
i) 0,5 ≦ a ≦ 2,
ii) 0,6 ≦ b ≦ 6 und
iii) 3,5 ≦ c ≦ 6,5.

8. Verfahren nach einem der Ansprüche 4 bis 7, wobei die Verbindung die nominale Zusammensetzung:
Tl_{0,5}BaCu₃O_{4,8+x},
Tl₂BaCu₃O₇₊ₓ,
Tl₅BaCu₃O_{11,5+x},
TlBa₂Cu₃O_{6,5+x}
oder
TlBaCu₃O_{5,5+x}
aufweist.

## Revendications

1. Composé supraconducteur de formule générale
TlBaₐCu_{b}O_{c}
dans laquelle :
a a une valeur supérieure ou égale à 0,2 et inférieure ou égale à 5 ;
b a une valeur supérieure ou égale à 0,5 et inférieure ou égale à 15 ; et
c a une valeur supérieure ou égale à a+b et inférieure ou égale à 2+a+b ;
le composé ayant une température critique d'au moins 85K.

2. Composé selon la revendication 1, dans lequel :
i) 0,5 ≦ a ≦ 2 ;
ii) 0,6 ≦ b ≦ 6 ; et
iii) 3,5 ≦ c ≦ 6,5 .

3. Composé selon la revendication 1 ou 2, qui a la composition nominale suivante :
Tl_{0,5}BaCu₃O_{4,8+x} ;
Tl₂BaCu₃O₇₊ₓ ;
Tl₅BaCu₃O_{11,5+x} ;
TlBa₂Cu₃O_{6,5+x} ;
ou
TlBaCu₃O_{5,5+x} .

4. Procédé pour préparer un composé supraconducteur de formule générale
TlBaₐCu_{b}O_{c}
dans laquelle :
a a une valeur supérieure ou égale à 0,2 et inférieure ou égale à 5 ;
b a une valeur supérieure ou égale à 0,5 et inférieure ou égale à 15 ; et
c a une valeur supérieure ou égale à a+b et inférieure ou égale à 2+a+b ;
le composé ayant une température critique d'au moins 85K, ce procédé comprenant :
(a) le mélange d'oxyde de cuivre, de carbonate de baryum et éventuellement d'oxyde de thallium ;
(b) éventuellement, le broyage et le chauffage du mélange obtenu ;
(c) le mélange avec le mélange obtenu de Tl₂O₃, s'il n'a pas déjà été ajouté ; et
(d) le chauffage du mélange obtenu, dans l'air ou dans un courant d'oxygène.

5. Procédé selon la revendication 4, dans lequel le chauffage éventuel à l'étape (b) s'effectue à une température de 900 à 950°C pendant au moins 24 heures.

6. Procédé selon la revendication 4 ou 5, dans lequel le chauffage à l'étape (d) s'effectue à une température de 900 à 950°C et/ou dans un courant d'oxygène pendant 2 à 5 minutes.

7. Procédé selon l'une quelconque des revendications 4 à 6, dans lequel :
i) 0,5 ≦ a ≦ 2 ;
ii) 0,6 ≦ b ≦ 6 ; et
iii) 3,5 ≦ c ≦ 6 .

8. Procédé selon l'une quelconque des revendications 4 à 7, dans lequel le composé a la composition nominale suivante :
Tl_{0,5}BaCu₃O_{4,8+x} ;
Tl₂BaCu₃O₇₊ₓ ;
Tl₅BaCu₃O_{11,5+x} ;
TlBa₂Cu₃O_{6.5+x} ;
ou
TlBaCu₃O_{5.5+x} .
